# EUROPEAN PATENT SPECIFICATION

(11) **EP 1 227 575 B1**
(45) Date of publication and mention of the grant of the patent: **08.06.2005**
(21) Application number: 02001340.5
(22) Date of filing: 18.01.2002
(51) Int. Cl.: H03B 19/03

(54) **Method for multiplying a frequency and instrument for multiplying a frequency**
Verfahren und Vorrichtung zum Vervielfachung einer Frequenz
Méthode et appareil pour la multiplication d'une fréquence

(30) Priority: 22.01.2001 JP 2001012644
(43) Date of publication of application: 31.07.2002
(73) Proprietor: HOKKAIDO UNIVERSITY, Sapporo City Hokkaido (JP)
(72) Inventor: Watanabe, Hideki, Ebetsu City, Hokkaido (JP); Sawamura, Makoto, Sapporo City, Hokkaido (JP); Sueoka, Kazuhisa, Sapporo City, Hokkaido (JP); Mukasa, Koichi, Sapporo City, Hokkaido (JP); Nakane, Ryosho, Sapporo City, Hokkaido (JP)
(74) Representative: von Hellfeld, Axel, Dr. Dipl.-Phys.

(56) References cited:
- US-A- 3 771 044
- US-A- 4 527 137

## Description

### Background of the Invention

### Field of the Invention:

This invention relates to a method for multiplying a frequency and an instrument for multiplying a frequency, particularly usable for micro wave technique field and high frequency technique field which require to multiply a frequency from a mobile communication device or a cellular information instrument, effectively.

### Description of the prior art:

A frequency generated at and transmitted from a mobile communication device or a cellular information instrument is multiplied by taking advantage of the non-linear resistance performance of a crystal detector. In this case, however, since many elements must be controlled and matched, the operation becomes complicated.

On the contrary, a monolithic micro wave integrated circuit is employed in which a given micro wave circuit is fabricated, as a high velocity and high frequency circuit, on a single substrate. Since the mass productivity of the monolithic micro wave integrated circuit can be adjust in good condition, it is preferably employed for commercial use. However, it is desired that the monolithic integrated circuit can comply with a higher frequency, low cost, miniaturization and weight saving, and low electric power consumption.

US Pat. No. 4,527,137 to Hartley describes a frequency multiplier for electromagnetic waves in which multiples of the input frequency propagate while the input frequency evanesces. A rectangular waveguide or other suitable wave conveying element with a cut-off frequency above the input frequency but below the output frequency contains the multiplying structure. The input frequency is multiplied using a post located in the waveguide or other element adjacent to the source of input waves. The post may define a multiplier gap between one of its surfaces and a wall of the waveguide or other element, in which case the multiplier gap may contain a multipactor between its surfaces which generates multiples of the input frequency. The multiplier gap may alternatively contain a non-linear element responsive to a high electric field, such as a ferroelectric material, which also generates multiples of the input frequency. Alternatively, the post may be surrounded by a non-linear element of ferromagnetic material responsive to a strong magnetic field. In either embodiment, waves at the same frequency as the input waves cannot propagate, but waves above the cut-off frequency propagate through the waveguide or other element to an output aperture.

US Pat. No. 3,771,044 to Cohen et al. relates to an apparatus for frequency doubling and limiting over a broad band of frequencies using a magneto-resistive effect in a magnetic film. The apparatus includes a thin plate of magneto-resistive, ferromagnetic material immersed in an electronically generated rotating magnetic field. In operation, an external power source provides a constant DC current through the plate. When a signal at frequency *f*₁ is impressed at the input terminals of the coils generating the rotating magnetic field, a signal at 2 *f*₁ appears at the output terminals of the magneto-resistive element. As the frequency of the input drive signal is changed, the output signal will continuously follow the input signal but at double the frequency without use of an output filter. The amplitude of the output signal is directly proportional to the magnitude of the impressed DC current and to the magnitude of the spatial magneto-resistance effect in the plate. At sufficiently large input levels, the amplitude of the output signal will remain constant with input signal level. The device is capable of functioning as a frequency doubler and limited on a frequency range from sub-audio to VHF.

### Summary of the Invention

It is an object of the present invention, in this point of view, to provide a new method as defined in claim 1 for multiplying a frequency and an instrument as defined in claim 11 usable for the same method.

For achieving the above object, this invention relates to a method for multiplying a frequency, comprising the steps of:
preparing a ferromagnetic film which has its inherent resonance frequency, and
introducing an electromagnetic wave which has an input frequency equal to the resonance frequency of the ferromagnetic film into said film thereby inducing a ferromagnetic resonance in the ferromagnetic film and using said induced resonance multiply the input frequency of the electromagnetic wave introduced.

The inventors had intensely studied to find out a new multiplying method of frequency. As a result, they found out quite a new method to multiplying a frequency by taking advantage of the ferromagnetic resonance of a ferromagnetic film, as mentioned above.

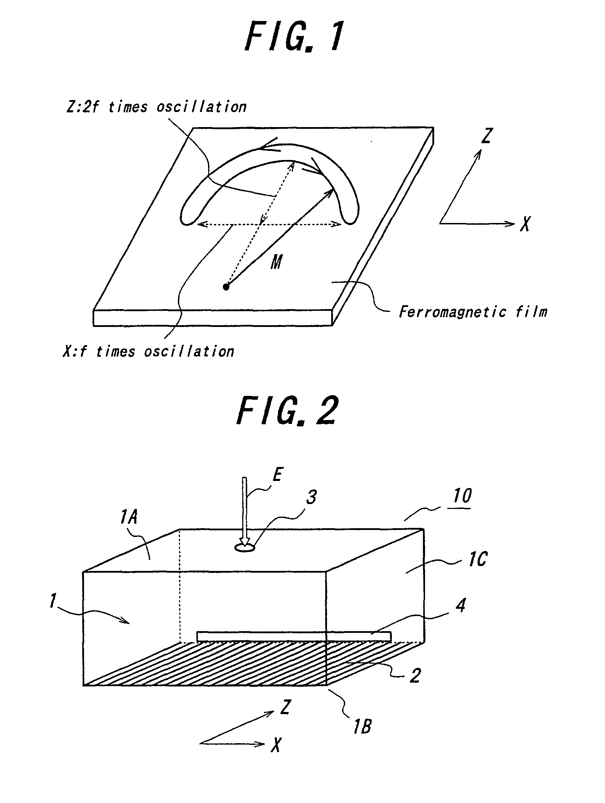

Fig. 1 is an explanatory view for the principle of the multiplying method of frequency according to the present invention. In the ferromagnetic resonance of a ferromagnetic film, the magnetic moment M is affected by the diamagnetic field which is generated in the direction perpendicular to the main surface of the ferromagnetic film, and thus, precesses in large amplitude in the direction parallel to the main surface and in small amplitude in the direction perpendicular to the main surface. In this case, the magnetic moment M oscillates twice in a Z direction while once in a X direction, as shown in Fig. 1. Therefore, if a ferromagnetic resonance is generated at a resonance frequency of f, the magnetic moment M oscillates f times in the X direction and 2f times in the Z direction.

If an electromagnetic wave having almost the same input frequency as the resonance frequency f is introduced into the ferromagnetic film, such a ferromagnetic resonance as mentioned above is generated, and the magnetic moment M oscillates in a frequency of 2f in the Z direction, to radiate an electromagnetic wave having a frequency of 2f. As a result, the input frequency of the electromagnetic wave introduced is multiplied twice. That is, the frequency of a given electromagnetic wave can be easily multiplied by taking advantage of the ferromagnetic resonance of a ferromagnetic film.

The resonance frequency of a ferromagnetic film to be used in the present invention can be adjusted appropriately dependent on the sort of the ferromagnetic material of the film and the thickness of the film, etc. Therefore, the input frequency of the electromagnetic wave can be multiplied within a wide range.

Also, since the dimension of the ferromagnetic film is set to nm order, the multiplying instrument to be used can be miniaturized. Moreover, since the ferromagnetic resonance is generated without an external magnetic field, excess electric power can not be consumed to generate the magnetic field, and thus, low electric power consumption can be realized.

In addition, the ferromagnetic film may be made of a Co single crystal film which is not expensive in cost, as will be mentioned below, and additional external magnet is not employed, as mentioned above. Therefore, the multiplying method and the multiplying instrument of the present invention can comply with low cost.

### Brief Description of the Drawings

For better understanding of the present invention, reference is made to the attached drawings, wherein
Fig. 1 is an explanatory view for the principle of the multiplying method of frequency according to the present invention, and
Fig. 2 is a perspective view showing a multiplying instrument to be used in a multiplying method of frequency according to the present invention.

### Description of the Preferred Embodiments

This invention will be described in detail with reference to the accompanying drawings. Fig. 2 is a perspective view showing a multiplying instrument to be used in a multiplying method of frequency according to the present invention. A multiplying instrument of frequency 10 shown in Fig. 1 includes a cavity resonator 1 and a ferromagnetic film 2 having a resonance frequency f provided on the bottom wall surface 1B inside the cavity resonator 1. Then, at the wall surface 1A of the cavity resonator 1 opposite to the ferromagnetic film 2 is formed an orifice 3, and at the side wall surface 1C of the cavity resonator 1 is formed a slit 4.

An electromagnetic wave E having a given input frequency to be multiplied is introduced into the cavity resonator 1 from the orifice 3. In this case, it is required that the input frequency of the wave is set equal to the resonance frequency f of the ferromagnetic film 2. As mentioned above, since the resonance frequency f can be varied within a wide range by selecting the ferromagnetic material, the dimension and so on of the film, the multiplying instrument 10 can cope with the electromagnetic wave E having a wide range input frequency.

After the introduction into the cavity resonator 1, the electromagnetic wave E generate a ferromagnetic resonance in the ferromagnetic film 2. In this case, as explained above, with reference to Fig. 1, the magnetic moment oscillates twice in a Z direction while once in a X direction. Therefore, an electromagnetic wave having a frequency 2f twice as large as the input frequency of the electromagnetic wave E is generated and radiated, and then, taken out of the slit 4, which is provided in the Z direction.

In Fig. 2, the X direction and the Z direction are set for the sake of convenience, and thus, they may be set appropriately in the main surface of the ferromagnetic film 2. However, it is required for takeout that a given slit is provided in a newly set Z direction.

In Fig. 2, although only the single ferromagnetic film 2 is provided in the cavity resonator 1 so as to multiply the input frequency of the electromagnetic wave E, a plurality of ferromagnetic films may be provided so as to multiply the input frequency several times, and thus, generate an electromagnetic wave having a higher frequency.

In the several times multiplication, a plurality of ferromagnetic films which have their respective resonance frequencies of f, 2f, 4f.....2nf (n: natural number) are provided and arranged, in turn, in the same plane. Then, an electromagnetic wave (first electromagnetic wave) having an input frequency equal to the first resonance frequency f is introduced to the first ferromagnetic film of the frequency f, to generate and irradiate an electromagnetic wave (second electromagnetic wave) having the second resonance frequency 2f twice as large as the first resonance frequency f.

Then, the second magnetic wave is introduced to the second ferromagnetic film of the second resonance frequency 2f, to generate and irradiate an electromagnetic wave (third electromagnetic wave) having the third resonance frequency 4f. Therefore, by repeating such an operation several times, finally, an electromagnetic wave having a frequency 2nf can be generated and irradiated. That is, if a plurality of ferromagnetic films having their respective 2nf times frequencies are arranged in turn, and a given electromagnetic wave having a frequency f is introduced to the ferromagnetic films in turn, from the first ferromagnetic film of the first frequency f to the final ferromagnetic film of the final frequency 2nf, the introduced electromagnetic wave is multiplied several times, to provide an electromagnetic film having a higher frequency easily.

For example, the plurality of ferromagnetic films may be arranged on the same bottom wall surface 1B of the single cavity resonator I, as shown in Fig. 2. Also, the plurality of ferromagnetic films are set in their respective cavity resonators, and the cavity resonators are arranged in turn, corresponding to the amplitudes of the resonance frequencies of the ferromagnetic films.

The ferromagnetic film is made of a material to generate a ferromagnetic resonance. For example, the ferromagnetic film may be made of a well known ferromagnetic material such as Fe, Ni, Co and alloy of these elements. Particularly, it is desired that the ferromagnetic film is made of a Co single crystal film.

Since such a Co single crystal film has a face centered cubic crystal structure, and thus, has a higher magnetocrystalline anisotropy, a given ferromagnetic resonance can be easily generated therein without an external magnetic field only by introducing an electromagnetic wave having a frequency almost equal to the resonance frequency. In this case, since additional external magnet is not needed and thus, excess electric power is not consumed, the low electric power consumption can be realized in the multiplying instrument and thus, the multiplying method of the present invention. Moreover, since the construction and mechanism of the multiplying instrument is simplified and such a Co single crystal film as not expensive is used, the multiplying instrument and the multiplying method of the present invention can comply with the requirement of low cost.

If the ferromagnetic film is made of the Co single crystal film, the thickness is preferably set within 0.5-5nm, particularly within 1-2nm. In this case, the magnetic moment can precess in the main surface, and thus, a given ferromagnetic resonance can be easily realized.

The length of the ferromagnetic film is set within 0.5-30nm, and the width of the ferromagnetic film is set within 0.5-30nm. Therefore, the multiplying instrument as shown in Fig. 2 can be miniaturized sufficiently.

Although the present invention was described in detail with reference to the above examples, this invention is not limited to the above disclosure and every kind of variation and modification may be made without departing from the scope of the present invention.

As mentioned above, according to the multiplying method and the multiplying instrument of the present invention, an input frequency of an electromagnetic wave can be easily multiplied by taking advantage of the ferromagnetic resonance of a given ferromagnetic film.

## Claims

1. A method for multiplying a frequency, comprising the steps of:
providing a ferromagnetic film (2) which has an inherent resonance frequency, and
introducing an electromagnetic wave which has an input frequency equal to said resonance frequency of said ferromagnetic film into said film, thereby inducing a ferromagnetic resonance in said ferromagnetic film (2) and using said induced resonance to multiply said input frequency of said electromagnetic wave introduced.

2. A multiplying method as defined in claim 1, wherein said input frequency of said electromagnetic wave introduced is multiplied twice by said ferromagnetic resonance of said ferromagnetic film (2).

3. A multiplying method as defined in any of the preceding claims, wherein the ferromagnetic film (2) is disposed within a cavity resonator (1).

4. A multiplying method as defined in claim 3, wherein the electromagnetic wave is introduced from an orifice (3) within said cavity resonator (1) into said cavity resonator (1).

5. A multiplying method as defined in claim 3 or 4, further comprising the step of removing the electromagnetic wave having the multiplied frequency out of a slit (4) formed in the cavity resonator (1).

6. A multiplying method as defined in any of the preceding claims, wherein a plurality of ferromagnetic films (2), each having inherent resonance frequencies are provided.

7. A multiplying method as defined in claim 6, wherein the plurality of ferromagnetic films (2) are adjacent, and further comprising the step of introducing said electromagnetic wave which has said multiplied frequency to the ferromagnetic film (2) adjacent to said one of said ferromagnetic films (2) in turn, thereby to multiply said input frequency of said electromagnetic wave several times.

8. A multiplying method as defined in claim 7, wherein said input frequency of said electromagnetic wave is multiplied twice at each of said ferromagnetic films (2).

9. A multiplying method as defined in any of the preceding claims, wherein said ferromagnetic film (2) is made of a Co single crystal film (2).

10. A multiplying method as defined in any of the preceding claims, wherein the thickness of said ferromagnetic film (2) is set within 0.5-5 nm

11. An instrument (10) for multiplying a frequency, comprising:
a cavity resonator (1), and
a ferromagnetic film (2) which has an inherent resonance frequency disposed in said cavity resonator (1),
said cavity resonator (1) including an orifice (3) to introduce an electromagnetic wave which has a given input frequency equal to said resonance frequency and a slit (4) to take an electromagnetic wave out of said cavity resonator (1) having a frequency which is a multiple of said resonance frequency.

12. A multiplying instrument (10) as defined in claim 11, wherein said ferromagnetic film (2) is made of a Co single crystal film (2).

13. A multiplying instrument (10) as defined in claim 11 or 12, wherein the thickness of said ferromagnetic film (2) is set within 0.5-5nm.

14. A multiplying instrument (10) as defined in any one of claims 11-13, wherein said input frequency of said electromagnetic wave is multiplied twice.

## Patentansprüche

1. Verfahren zum Vervielfachen einer Frequenz, das die Schritte aufweist:
Bereitstellen eines ferromagnetischen Films (2), der eine inhärente Resonanzfrequenz hat, und
Einleiten einer elektromagnetischen Welle in diesen Film, die eine Eingangsfrequenz gleich der Resonanzfrequenz des ferromagnetischen Films (2) hat , wodurch eine ferromagnetische Resonanz im ferromagnetischen Film (2) induziert wird und Verwenden der induzierten Resonanz, um die Eingangsfrequenz der eingeleiteten elektromagnetischen Welle zu vervielfachen.

2. Vervielfachungsverfahren nach Anspruch 1, bei dem die Eingangsfrequenz der eingeleiteten elektromagnetischen Welle durch die ferromagnetische Resonanz des ferromagnetischen Films (2) zwei mal vervielfacht wird.

3. Vervielfachungsverfahren nach einem der vorherigen Ansprüche, bei dem der ferromagnetische Film (2) in einem Hohlraumresonator (1) angeordnet ist.

4. Vervielfachungsverfahren nach Anspruch 3, bei dem die elektromagnetische Welle von einer Öffnung (3) im Hohlraumresonator (1) in den Hohlraumresonator (1) eingeleitet wird.

5. Vervielfachungsverfahren nach Anspruch 3 oder 4, das ferner den Schritt des Entfernens der elektromagnetischen Welle mit der vervielfachten Frequenz aus einem im Hohlraumresonator (1) ausgeformten Schlitz (4) aufweist.

6. Vervielfachungsverfahren nach einem der vorherigen Ansprüche, bei dem eine Mehrzahl ferromagnetischer Filme (2) bereitgestellt wird, von denen ein jeder eine inhärente Resonanzfrequenz hat.

7. Vervielfachungsverfahren nach Anspruch 6, bei dem die Mehrzahl der ferromagnetischen Filme (2) benachbart ist, und das ferner den Schritt des Einleitens der elektromagnetischen Welle mit der vervielfachten Frequenz nacheinander in den ferromagnetischen Film (2) neben einem der ferromagnetischen Filme (2) aufweist, um **dadurch** die Eingangsfrequenz der ferromagnetischen Welle mehrere Male zu vervielfachen.

8. Vervielfachungsverfahren nach Anspruch 7, bei dem die Eingangsfrequenz der ferromagnetischen Welle an jedem der ferromagnetischen Filme (2) zwei mal vervielfacht wird.

9. Vervielfachungsvertahren nach einem der vorherigen Ansprüche, bei der ferromagnetische Film (2) aus einem Co-Einkristallfilm (2) besteht.

10. Vervielfachungsverfahren nach einem der vorherigen Ansprüche, bei dem die Dicke des ferromagnetischen Films (2) zwischen 0,5 und 5 nm eingestellt ist.

11. Instrument (10) zur Vervielfachung einer Frequenz, aufweisend:
einen Hohlraumresonator (1) und
einen im Hohlraumresonator (1) angeordneten ferromagnetischen Film (2), der eine inhärente Resonanzfrequenz hat,
wobei der Hohlraumresonator (1) eine Öffnung (3) enthält, um eine elektromagnetische Welle einzuleiten, die eine gegebene Eingangsfrequenz gleich der Resonanzfrequenz hat und einen Schlitz (4), um eine elektromagnetische Welle aus dem Hohlraumresonator (1) zu entfernen, die eine Frequenz hat, die einem Vielfachen der Resonanzfrequenz entspricht.

12. Vervielfachungsinstrument (10) nach Anspruch 11, bei dem der ferromagnetische Film (2) aus einem Co-Einkristallfilm (2) besteht.

13. Vervielfachungsinstrument (10) nach Anspruch 11 oder 12, bei dem die Dicke des ferromagnetischen Films (2) zwischen 0,5 und 5 nm eingestellt ist.

14. Vervielfachungsinstrument (10) nach einem der Ansprüche 11 bis 13, bei dem die Eingangsfrequenz zwei mal vervielfacht wird.

## Revendications

1. Procédé de multiplication d'une fréquence, comprenant les étapes de :
fourniture d'un film ferromagnétique (2) qui a une fréquence de résonance intrinsèque, et
introduction d'une onde électromagnétique qui a une fréquence d'entrée égale à ladite fréquence de résonance dudit film ferromagnétique dans ledit film (2), introduisant ainsi une résonance ferromagnétique dans ledit film ferromagnétique (2) et utilisation de ladite résonance induite pour multiplier ladite fréquence d'entrée de ladite onde électromagnétique introduite.

2. Procédé de multiplication selon la revendication 1, dans lequel ladite fréquence de ladite onde électromagnétique introduite est multipliée deux fois par ladite résonance ferromagnétique dudit film ferromagnétique (2).

3. Procédé de multiplication selon l'une quelconque des revendications précédentes, dans lequel le film ferromagnétique (2) est disposé dans un résonateur de cavité (1).

4. Procédé de multiplication selon la revendication 3, dans lequel l'onde électromagnétique est introduite à partir d'un orifice (3) dans ledit résonateur de cavité (1).

5. Procédé de multiplication selon la revendication 3 ou 4, comprenant en outre l'étape d'enlèvement de l'onde électromagnétique ayant la fréquence multipliée à partir d'une fente (4) formée dans le résonateur de cavité (1).

6. Procédé de multiplication tel que défini dans l'une quelconque des revendications précédentes, dans lequel une pluralité de films ferromagnétiques (2), ayant chacun des fréquences de résonance intrinsèque sont fournis.

7. Procédé de multiplication selon la revendication 6, dans lequel la pluralité de films ferromagnétiques (2) sont adjacents, et comprenant en outre l'étape d'introduction de ladite onde électromagnétique qui a ladite fréquence multipliée dans le film ferromagnétique (2) adjacent à un desdits films ferromagnétiques (2) à leur tour, pour ainsi multiplier ladite fréquence d'entrée de ladite onde électromagnétique plusieurs fois.

8. Procédé de multiplication selon la revendication 7, dans lequel ladite fréquence d'entrée de ladite onde électromagnétique est multipliée deux fois à chacun desdits films ferromagnétiques (2).

9. Procédé de multiplication selon l'une quelconque des revendications précédentes, dans lequel ledit film ferromagnétique (2) est constitué d'un film monocristallin de Co (2).

10. Procédé de multiplication selon l'une quelconque des revendications précédentes, dans lequel l'épaisseur dudit film ferromagnétique (2) est réglée dans 0,5 à 5 nm.

11. Instrument (10) pour multiplier une fréquence comprenant :
un résonateur de cavité (1), et
un film ferromagnétique (2) qui a une fréquence de résonance intrinsèque disposé dans ledit résonateur de cavité (1),
ledit résonateur de cavité (1) comprenant un orifice (3) pour introduire une onde électromagnétique qui a une fréquence d'entrée donnée égale à ladite fréquence de résonance et une fente (4) pour sortir une onde électromagnétique dudit résonateur de cavité (1) ayant une fréquence qui est un multiple de ladite fréquence de résonance.

12. Instrument de multiplication (10) tel que défini dans la revendication 11, dans lequel ledit film ferromagnétique (2) est constitué d'un film monocristallin de Co (2).

13. Instrument de multiplication (10) selon la revendication 11 ou 12, dans lequel l'épaisseur dudit film ferromagnétique (2) est de 0,5 à 5 nm.

14. Instrument de multiplication (10) tel que défini dans l'une quelconque des revendications 11 à 13, dans lequel ladite fréquence d'entrée de ladite onde électromagnétique est multipliée deux fois.
